# EUROPEAN PATENT SPECIFICATION

(11) **EP 2 613 346 B1**
(45) Date of publication and mention of the grant of the patent: **08.06.2022**
(21) Application number: 12778033.6
(22) Date of filing: 19.09.2012
(51) Int. Cl.: H01L 21/336, H01L 29/786, H01L 29/51, H01L 21/28, H01L 29/49

(54) **THIN FILM TRANSISTOR, MANUFACTURING METHOD THEREOF AND DISPLAY DEVICE**
DÜNNFILMTRANSISTOR, HERSTELLUNGSVERFAHREN DAFÜR UND ANZEIGEVORRICHTUNG DAMIT
TRANSISTOR EN COUCHES MINCES, PROCÉDÉ DE FABRICATION DE CELUI-CI ET DISPOSITIF D'AFFICHAGE

(30) Priority: 11.11.2011 WO PCT/CN2011/035931
(43) Date of publication of application: 10.07.2013
(73) Proprietor: BOE Technology Group Co., Ltd., Beijing 100015 (CN)
(72) Inventor: LI, Yanzhao, Beijing 100176 (CN); WANG, Gang, Beijing 100176 (CN); SUN, Li, Beijing 100176 (CN); GUAN, Shuang, Beijing 100176 (CN)
(74) Representative: Klunker IP Patentanwälte PartG mbB
(86) International application number: PCT/CN2012/081614
(87) International publication number: WO 2013/067855

(56) References cited:
- EP-A2- 2 006 903
- CN-A- 1 188 243
- CN-A- 102 646 595
- US-A- 4 748 485
- US-A- 4 996 575
- US-A- 5 834 797
- US-A1- 2003 034 940
- US-A1- 2004 217 431
- US-A1- 2008 265 323
- US-A1- 2009 184 632
- US-A1- 2011 114 961
- KOW-MING CHANG ET AL: "Electrical characteristics of low temperature polysilicon TFT with a novel TEOS/oxynitride stack gate dielectric", IEEE ELECTRON DEVICE LETTERS, IEEE SERVICE CENTER, NEW YORK, NY, US, vol. 24, no. 8, 1 August 2003 (2003-08-01) , pages 512-514, XP011430773, ISSN: 0741-3106, DOI: 10.1109/LED.2003.815155
- YAMAMOTO S ET AL: "SILICON SURFACE NITRIFICATION USING HYDROGEN AND AMMONIA BY HYBRID EXCITATION", ELECTRONICS & COMMUNICATIONS IN JAPAN, PART II - ELECTRONICS, WILEY, HOBOKEN, NJ, US, vol. 76, no. 3, 1 March 1993 (1993-03-01), pages 74-83, XP000420768, ISSN: 8756-663X
- WU W S ET AL: "Characterization of SiO2 Films Deposited by Pyrolysis of Tetraethylorthosilicate (TEOS)", SOLID STATE DEVICE RESEARCH CONFERENCE, 1988. ESSDERC '88. 18TH EUROPEAN, IEEE, PISCATAWAY, NJ, USA, 13 September 1988 (1988-09-13), pages c4-397, XP031652316, ISBN: 978-2-86883-099-9

## Description

### FIELD OF THE INVENTION

Embodiments of the present invention relate to a thin film transistor (TFT), a manufacturing method thereof and a display device.

### BACKGROUND OF THE INVENTION

Thin Film Transistors (TFTs) have been used in a variety of electro-optical devices, such as liquid crystal display devices and semiconductor devices. In a TFT, the quality of a gate insulating layer has an extremely important effect on the electrical properties of the TFT. Using a gate insulating material with a high-quality and a high K-value (i.e., dielectric constant) can improve the device performances of a TFT to a large extent, for example, it can lower a threshold voltage, increase a Iₒₙ/I_{off} ratio and decrease a sub-threshold swing.

Conventional TFT devices use processes such as chemical vapor deposition (CVD) and sputtering to deposit a SiO₂ or SiNₓ film as a gate insulating layer. For example, Kow-Ming Chang, et al., in "Electrical Characteristics of Low Temperature Polysilicon TFT With a Novel TEOS/Oxynitride Stack Gate Dielectric", IEEE ELECTRON DEVICE LETTERS, Vol. 24, No. 8, August 2003 disclose a method for preparing a gate insulating layer with a process of using tetraethyl orthosilicate (TEOS). However, this method is still a CVD process, and the formed gate insulating thin layer has a relatively loosen texture and an unsatisfactory insulating property (only achieving approximately 5.6×10⁶ V·cm⁻¹) due to a relatively low formation temperature, which will affect the device performances due to a too large leakage current for the TFT device. If the gate insulating layer is thickened, the operating voltage of the device may be increased, and the process time may be extended.

US 2009/0184632 A1 discloses a TFT and a method of fabricating the same, and an organic light emitting diode (OLED) display device having the same, wherein the TFT includes a substrate, a semiconductor layer disposed on the substrate and including a channel region, and source and drain regions, the channel region being doped with impurities, a thermal oxide layer disposed on the semiconductor layer, a silicon nitride layer disposed on the thermal oxide layer, a gate electrode disposed on the silicon nitride layer and corresponding to a predetermined region of the semiconductor layer, an interlayer insulating layer disposed on the entire surface of the substrate, and source and drain electrodes electrically connected with the semiconductor layer.

EP 2 006 903 A2 discloses a method of fabricating a polycrystalline silicon (poly-Si) layer including: providing a substrate, forming an amorphous silicon (a-Si) layer on the substrate, forming a thermal oxide layer to a thickness of about 10 to 50Å on the a-Si layer, forming a metal catalyst layer on the thermal oxide layer, and annealing the substrate to crystallize the a-Si layer into the poly-Si layer using a metal catalyst of the metal catalyst layer, wherein the a-Si layer is crystallized into a poly-Si layer by a super grain silicon (SGS) crystallization method, and wherein the thermal oxide layer is formed during the dehydrogenation of the a-Si layer.

US 2003/0034940 A1 discloses a driver circuit integration type (monolithic type) active matrix display device formed by using thin film transistors (TFT). While a nickel element is added to an amorphous silicon film, a heat treatment is carried out to thereby crystallize the amorphous silicon film. Further, by carrying out the heat treatment in an oxidizing atmosphere containing a halogen element, a thermal oxidation film is formed. At this time, cyrstallinity is improved and gettering of the nickel element proceeds. TFTs are formed by using the thus obtained crystalline silicon film.

US 2004/0217431 A1 discloses a semiconductor device having a gate insulator layer in which the contamination with oxygen atoms is controlled and a method for manufacturing the same, wherein the semiconductor device comprises: a semiconductor layer; a gate insulator layer formed on the semiconductor layer; and a gate electrode formed on the gate insulator layer, wherein the atomic ratio of oxygen atoms included in the gate insulator layer is 5 atm. % or below.

Yamamoto, S. and Migitaka, M., in "Silicon surface nitrification using hydrogen and ammonia by hybrid excitation", Electron. Comm. Jpn. Pt. II, vol. 76, No. 3, March 1993, p. 74-84, ISSN: 8756-663X, disclose a hybrid-excitation technique using plasma excitation and photoexcitation in chemical vapor phase reaction, using this technique, the silicon surface was nitrified in a mixture of ammonia (NH3) and hydrogen (H2) gases. First, a (100) Si substrate heated at 180°C was illuminated by ultraviolet ray (wavelengths: 184.9 nm and 253.7 nm) under NH3 atmosphere. At the same time, hydrogen radicals generated by decomposition of H2 gas in an RF (13.56 MHZ) inductive discharge tube were supplied to the substrate. Auger analysis indicated that the (100) Si surface up to about 1 nm in depth was nitrified and that the hybrid excitation was based on the synergy effect of photoexcitation and hydrogen radical excitation. Next, staggered-structure thin-film transistors were fabricated using amorphous Si whose surfaces nitrified by the foregoing method and the conventional plasma excitation method.

US 2008/0265323 A1 discloses a semiconductor device and a manufacturing method thereof, wherein an insulating film including an opening is formed over a base substrate and a part of a bond substrate is transferred to the base substrate, with the insulating film interposed therebetween, whereby a semiconductor film including a cavity between the semiconductor film and the base substrate is formed over the base substrate. Then, a semiconductor device including a semiconductor element such as a transistor is manufactured using the semiconductor film. The transistor includes a cavity between the base substrate and the semiconductor film used as an active layer. One cavity may be provided or a plurality of cavities may be provided.

W. S. Wu et al. in "Characterization of SiO2 Films Deposited by Pyrolysis of Tetraethylorthosilicate (TEOS)", SOLID STATE DEVICE RESEARCH CONFERENCE, 1988, ESSDERC '88, 18th EUROEPAN, IEEE, PISCATAWAY, NJ, USA, 13 September 1988, pp. c4-397, ISBN: 978-2-86883-099-9, concerns deposition rate, thickness uniformity and step coverage of SiO2 films deposited on Si-substrates by pyrolysis of TEOS studied as a function of process parameters: temperature, pressure, and gas flow. Oxide films with uniformities of ±1% on 100 mm wafers and step coverage of 76% on 1 µm wide and deep trenches have been obtained. The electrical characterization of TEOS-SiO2 films deposited on single crystal Si shows a charge density of about 10¹¹ cm⁻², a surface state density at Si midgap lower than 10¹⁰ eV⁻¹ cm⁻², a Si/SiO 2 barrier height of 2.6 eV and a breakdown field strength from 7.5 to 9 MV/cm. TEOS-SiO2 films deposited on POC13 doped poly-Si show insulation properties comparable to that of SiO2 films grown at 1100°C.

### SUMMARY OF THE INVENTION

It is an object of the present invention to provide an improved method for manufacturing a TFT, especially a gate insulating layer thereof.

The object is achieved by the features of the respective independent claims. Further embodiments and developments are defined in the respective dependent claims.

### BRIEF DESCRIPTION OF THE DRAWINGS

In order to clearly illustrate the technical solutions of the embodiments of the invention, the drawings of the embodiments will be briefly described in the following; it is obvious that the described drawings are only related to some embodiments of the invention and thus are not limitative of the invention.
FIG. 1 shows a schematic illustration of a substrate used in a manufacturing process of a TFT device according to an example of the present invention;
FIG. 2 shows a schematic illustration of a structure formed in a manufacturing process of a TFT device according to an example of the present invention;
FIG. 3 shows a schematic illustration of a structure formed in a manufacturing process of a TFT device according to an example of the present invention;
FIG. 4 shows a schematic illustration of a structure formed in a manufacturing process of a TFT device according to an example of the present invention;
FIG. 5 shows a schematic illustration of a structure formed in a manufacturing process of a TFT device according to an example of the present invention; and
FIG. 6 shows a schematic illustration of a structure of a TFT device according to an example of the present invention.

### DETAILED DESCRIPTION OF THE PREFERRED EMBODIMENTS

In order to make objects, technical details and advantages of the embodiments of the invention apparent, the technical solutions of the embodiments will be described in a clearly and fully understandable way in connection with the drawings related to the embodiments of the invention. It is obvious that the described embodiments are just a part but not all of the embodiments of the invention. Based on the described embodiments herein, those skilled in the art can obtain other embodiment(s), without any inventive work, which should be within the scope of the invention as defined in the claims.

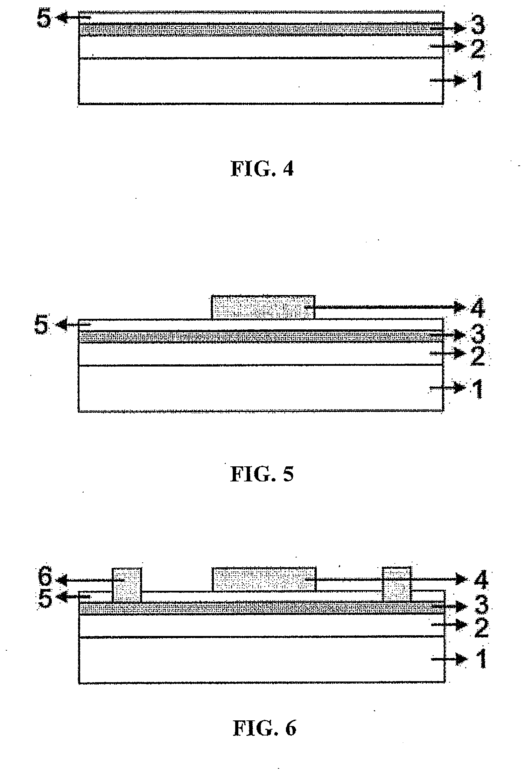

First of all, with reference to FIG. 6, a structure of a TFT device will be described. Specifically, the TFT device comprises a substrate 1, an active layer 3, a first gate insulating layer 5 located above the active layer 3, a gate electrode 4 located above the first gate insulating layer 5, and source/drain electrodes 6 in contact with the active layer 3 through openings in the first gate insulating layer 5. The first gate insulating layer 5 is in direct contact with the active layer 3. The TFT device 101 may further comprise a buffer layer 2 between the active layer 3 and the substrate 1. The buffer layer 2 may have a thickness of 5-1000 nm, and is formed of SiO2 or SiNx. The substrate 1 may be a transparent glass, and the substrate 1 may have a thickness of 30-1000 µm. However, the substrate 1 is not limited to the transparent glass, and may be other transparent or opaque substrates; moreover, the thickness of the substrate 1 is not limited to the thickness described above, either.

The active layer 3 is formed of polysilicon. The polysilicon may use the amorphous silicon obtained by an excimer laser annealing (ELA) process. For example, on the transparent substrate 1 deposited with a buffer layer 2 thereon, amorphous silicon with a thickness of 50-200nm is firstly deposited, and then the amorphous silicon layer is crystallized by using an equipment such as an ELA with a high energy (e.g., approximately 100-500 mJ·cm⁻²) to scan it, thereby converting it into a polysilicon layer.

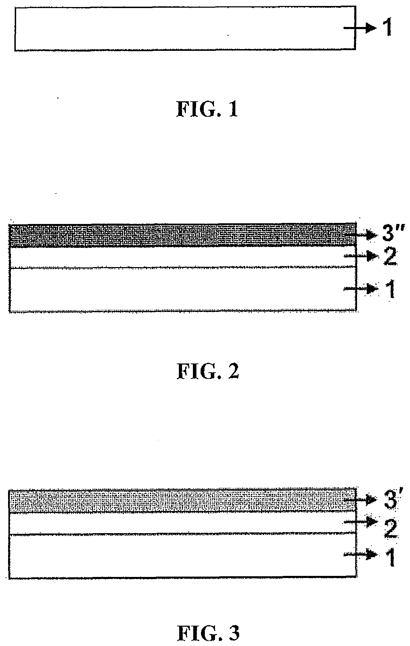

In a preferred example, a semiconductor layer 3' (e.g., a polysilicon layer, refer to FIG. 3) used for forming the active layer 3 may be placed in an oxidizing atmosphere (e.g., a nitrogen-containing or oxygen-containing atmosphere), and heated by means of convection heating or laser heating or the like, so that a surface of the semiconductor layer 3' directly forms a dense thermal-oxidized gate insulating layer 5. For example, in an oxygen-containing environment, by heating a semiconductor layer 3' (e.g., a polysilicon layer) used for forming the active layer 3, a dense thermal-oxidized gate insulating layer 5 (a thermal silicon oxide layer) can be directly formed. The gate insulating layer 5 may have a thickness of 1-100 nm. At this time, the surface layer of the semiconductor layer is oxidized to form a dense thermal-oxidized gate insulating layer 5; while the unoxidized portion in the semiconductor layer forms the active layer 3 (refer to FIG. 4).

In another example, an additional second gate insulating layer may be further formed on the gate insulating layer 5 by other methods (e.g., a CVD method or a sputtering method), thereby forming a composite gate insulating layer (not shown in the figure). The composite gate insulating layer may have a total thickness (i.e. the sum of the thicknesses of the first gate insulating layer and the second gate insulating layer) of 1-100 nm. At this time, the second gate insulating layer is located between the gate electrode 4 and the first gate insulating layer 5, and the source/drain electrodes 6 are in contact with the active layer 3 through openings in the composite gate insulating layer.

The gate electrode 4 may be formed above the gate insulating layer (in a top-gate structure) which is composed of the first gate insulating layer 5 or composed of the composite gate insulating layer described above. Alternatively, in a TFT with a bottom-gate structure, the gate electrode 4 may be formed on the substrate 1.

In one embodiment, the technical solution according to the embodiment of the present invention can be applied to a bottom-gate structure. In this case, the gate electrode 4 is provided over the substrate 1 (or the buffer layer 2), and the gate insulating layer is provided above the gate electrode 4. In this case, a gate electrode 4 may be formed at first, and then a semiconductor layer is formed above the gate electrode 4; next, the bottom of the semiconductor layer is formed into an insulating layer by implanting oxygen element to the bottom of the semiconductor layer. The insulating layer can be used as a gate insulating layer, while the unoxidized upper portion is used as an active layer. Certainly, in addition to the oxygen element implanted in the semiconductor layer used for oxidation as described above, other elements which have an oxidizing effect may also be used.

The gate electrode 4 has a thickness of 1-200 nm, and may be selected from materials of metals such as Mo, Cr, Au, and other alloys. The gate electrode 4 may be formed by patterning a metal gate layer. The source/drain electrodes 6 have a thickness of 5-300 nm, and may be selected from materials of metals such as Mo, Al, In, Ti, composite metals and alloys. The source/drain electrodes 6 may be formed by patterning the source/drain metal layer.

Hereinafter, with reference to FIGs. 1-6, a manufacturing process of a TFT device according to an example of the present invention will be described. FIG. 1 shows a transparent substrate 1 used in the manufacturing process of the TFT device according to an example of the present invention. The transparent substrate 1 may be cleaned according to a standard process, and then a buffer layer 2 and a semiconductor layer 3' are sequentially formed. For example, the semiconductor 3' may be formed by a method as follows: firstly, a semiconductor layer precursor 3" (e.g., amorphous silicon) is formed, thereby obtaining a structure as shown in FIG. 2; next, the semiconductor layer precursor 3" shown in FIG. 2 may be converted into a semiconductor layer 3' used for forming an active layer 3, thereby obtaining a structure as shown in FIG. 3. For example, in a vacuum environment, an amorphous silicon thin film is crystallized by means of laser crystallization or the like, and thus a polysilicon layer 3' is formed. It should be noted that, the method for forming the semiconductor layer 3' is not limited to the above-described method which forms a polysilicon layer by crystallizing amorphous silicon through a laser crystallization process.

FIG. 4 shows a schematic illustration of a structure obtained by forming a gate insulating layer 5 on a structure shown in FIG. 3. As an example, a surface of the semiconductor layer 3' (e.g., a polysilicon layer) may be treated with a 1% hydrofluoric acid (HF) at first, and then in an oxidizing atmosphere, the surface layer of the semiconductor layer 3' is thermal-oxidized into a dense gate insulating layer 5. Meanwhile, an unoxidized portion (the lower portion) in the semiconductor layer 3' forms an active layer 3.

The thermal oxidation may adopt a dry-thermal oxidation process or a wet-thermal oxidation process, and provides energy for the oxidation process by means of using an annealing furnace or ELA. Preferably, in an atmosphere used in a dry-thermal oxidation process, the oxygen content in volume is greater than 98%, and the water content in volume is less than 10 ppm. In an atmosphere used in a wet-thermal oxidation process, the oxygen content in volume is greater than 97%, and the water content in volume is 10-1000 ppm. An atmosphere for a wet-thermal oxidation process may be obtained by the following way: when oxygen goes through an annealing furnace, the oxygen is subjected to going through a container (e.g., a conical flask) or the like which contains deionized water, thereby the oxygen is naturally mixed with water vapor as it goes through the deionized water. At this time, the water content in volume is preferably 10-1000 ppm.

The skilled in the art will understand that, the oxidizing atmosphere not only comprises an oxygen-containing atmosphere, but also may comprise an atmosphere containing other oxidizing substances, for example a nitrogen-containing atmosphere. For example, a nitrogen-containing atmosphere may be an atmosphere containing N₂ or NH₃. Therefore, at this time, if the semiconductor layer 3' is polysilicon, then the resultant gate insulating layer 5 is made of SiNₓ.

In one example, another gate insulating layer may be deposited on the first gate insulating layer 5 by a conventional method (for example, CVD or a sputtering method). For example, in the case that the gate insulating layer 5 is made of SiO₂, the method according to the embodiment of the present invention further comprises: combing the thermal-oxidized SiO₂ and SiO₂ formed by other methods to form a gate insulating layer.

As shown in FIG. 5, next, a gate metal layer may be deposited, and a desired pattern is formed by means of photolithography or the like, so as to form a gate electrode 4. Then, by photolithography and etching processes, openings (contact holes) required for the contact between source/drain electrodes 6 and an active layer are etched out, and then a source/drain metal layer is deposited, and a desired pattern is formed by means of a photolithography process to form the source/drain electrodes 6, thereby obtaining the TFT device as shown in FIG. 6. At this time, the source/drain electrodes 6 are in contact with the active layer through the openings in the gate insulating layer 5. In the process of forming a composite gate insulating layer as described above, the source/drain electrodes 6 are in contact with the active layer through openings in the composite gate insulating layer. At the end, the resultant structure is tested and analyzed.

It should be understood that, the above only describes the manufacturing process of a TFT device having a top-gate structure, with reference to FIGs. 1-6. The method according to the embodiment of the invention can also be applicable to a TFT device having such as a bottom-gate structure.

Hereinafter, embodiments of the present invention will be further described in conjunction with specific examples, but the present invention is not limited to the following examples.

A comparative Example - Manufacturing of a SiO₂ gate insulating layer by a CVD method

Firstly, a quartz substrate is cleaned, and on the substrate, by using a CVD method, a 50 nm thickness of SiNₓ and a 300 nm thickness of SiO₂ are sequentially deposited as a buffer layer; then, a 100 nm thickness of amorphous silicon is deposited, and with the use of excimer laser, the amorphous silicon is subject to a crystallization process; thereafter, the sample is subject to a surface treatment with a 1% (in volume) HF; and then on the surface of the sample, by using a CVD method, a 50 nm thickness of SiO₂ thin film is deposited, and next, a Mo gate electrode and Mo/Al source/drain electrodes are sequentially formed thereon.

The SiO₂ thin film formed by this method is relatively loose, and has an ordinary gate insulating property, with a density of 1.9-2.3 g·cm⁻³, a refractive index of 1.43-1.45, and a dielectric strength of approximately 5.6×10⁶ V·cm⁻¹. The method can be applicable on ordinary glasses, and the deposition time of the SiO₂ thin film is about 1-10 minutes.

First Embodiment - Formation of a gate insulating layer by using an annealing furnace with a dry-thermal oxidation process

Firstly, a quartz substrate is cleaned, and on the substrate, by using a CVD method, a 50 nm thickness of SiNₓ and a 300 nm thickness of SiO₂ are sequentially deposited as a buffer layer; then, a 100 nm thickness of amorphous silicon is deposited, and with the use of excimer laser, the amorphous silicon is subject to a crystallization process; thereafter, the sample is subject to a surface treatment with a 1% (in volume) HF; and then the sample is placed in an annealing furnace in a pure dry oxygen atmosphere (with an oxygen content in volume greater than 98%, and a water content in volume less than 10 ppm); the annealing temperature is raised to 1000°C for oxidizing for 20 minutes, thereby forming a dense SiO2 thin film with a thickness of about 50 nm; and next, a Mo gate electrode and Mo/Al source/drain electrodes are sequentially deposited thereon.

The SiO2 thin film formed by this method is densest, and has a best gate insulating property, with a density of 2.0-2.4 g·cm-3, a refractive index of 1.45-1.47, and a dielectric strength of greater than 10×106 V·cm-1. The method can be applicable on high temperature resistant glass, and the deposition time of the SiO2 thin film is longer than 20 minutes.

Second Embodiment - Formation of a gate insulating layer by means of laser heating

Firstly, a glass substrate is cleaned, and on the substrate, by using a CVD method, a 100 nm thickness of SiNx and a 200 nm thickness of SiO2 are sequentially deposited as a buffer layer; then, a 100 nm thickness of amorphous silicon is deposited, and with the use of excimer laser, the amorphous silicon is subject to a crystallization process; thereafter, the sample is subject to a surface treatment with a 1% (in volume) HF; and then the sample is placed in a pure dry oxygen atmosphere (with an oxygen content in volume greater than 98%, and a water content in volume less than 10 ppm), and again by using near-infrared excimer laser with high energy density (100-500 mJ·cm-2) for scanning, a dense SiO2 thin film with about 30 nm thickness is formed; and next, a Mo gate electrode and Mo/Al source/drain electrodes are sequentially deposited thereon.

The SiO2 thin film formed by this method is dense, and has a good gate insulating property, with a density of 2.0-2.4 g·cm-3, a refractive index of 1.45-1.47, and a dielectric strength of 9×106 V·cm-1. The method can be applicable on ordinary high temperature glass, and the growth time of the SiO2 thin film is about 30-60 minutes (for a sample of 370 mm × 470 mm).

Third Embodiment - Manufacturing of a composite gate insulating thin film

Firstly, a glass substrate is cleaned, and on the substrate, by using a CVD method, a 200 nm thickness of SiNₓ and a 200 nm thickness of SiO₂ are sequentially deposited as a buffer layer; then, a 100 nm thickness of amorphous silicon is deposited, and with the use of excimer laser, the amorphous silicon is subject to a crystallization process; thereafter, the sample is subject to a surface treatment with a 1% (in volume) HF; and then the sample is placed in an annealing furnace in an atmosphere containing 1000ppm water, the annealing temperature is raised to 400°C for oxidizing for 100 seconds, thereby forming an about 5-10 nm thickness of a SiO₂ thin film. Next, by using a CVD method, a 40 nm thickness of SiO₂ is deposited thereon, and finally a Mo gate electrode and Mo/Al source/drain electrodes are sequentially formed.

In this method, the growth time of the SiO₂ thin film is as follows: the thermal oxidation time is about 60-300 seconds, thereafter the growth time of the CVD method is about 60-300 seconds, thus the total time is about 2-10 minutes; the 5-10 nm thickness of SiO₂ thin film near a contact surface between the active layer and the gate insulating layer is relatively dense and has a very good insulating property. The thermal-oxidized film layer has: a density of 2.0-2.4 g·cm⁻³, a refractive index of 1.45-1.47, and a dielectric strength of approximately 10×10⁶ V·cm⁻¹; the CVD deposited film layer has a density of 2.0-2.2 g·cm⁻³, a refractive index of 1.43-1.45, and a dielectric strength of approximately 6×10⁶ V·cm⁻¹. Thus, the quality of the contact interface between the active layer and the gate insulating layer can be ensured, and the process can be applicable on ordinary glass.

Fourth Embodiment - Formation of a gate insulating film made of SiNₓ

Firstly, a quartz substrate is cleaned, and on the substrate, by using a CVD method, a 50 nm thickness of SiNx and a 300 nm thickness of SiO2 are sequentially deposited as a buffer layer; then, a 100 nm thickness of amorphous silicon is deposited, and with the use of excimer laser, the amorphous silicon is subject to a crystallization process; thereafter, the sample is subject to a surface treatment with a 1% (in volume) HF; and then in an atmosphere containing NH3, with the use of an ELA process (with an energy density of approximately 100-500 mJ·cm-2), a 50 nm thickness of SiNx thin film is grown; and next, a Mo gate electrode and Mo/Al source/drain electrodes are sequentially deposited thereon.

The SiNx thin film formed by this method is relatively dense and has a relatively good insulating property, with a density of 3.2-3.5 g·cm-3, a refractive index of 1.43-1.45, and a dielectric strength greater than 1×107 V·cm-1. This method can be adapted to an ordinary glass, and the deposition time of the thin film is about 10-30 minutes.

Further, the embodiments of the present invention are not limited to the above examples. For example, although the above describes that both the source/drain electrodes 6 and the gate electrode 4 are provided above the active layer 3, the embodiments of the present invention, however, are not limited to this structure. It is also possible that, the source/drain electrodes 6 are provided below the active layer 3 while the gate electrode 4 is provided above the active layer. At this time, before the formation of a semiconductor layer precursor 3" used for the active layer 3, source/drain electrodes 6 are need to be formed on the substrate. After an active layer 3 is formed above the source/drain electrodes 6, the active layer 3 may be in contact with the source/drain electrodes 6. At this point, the process of forming a contact hole in the gate insulating layer for contact between the source/drain electrodes 6 and the active layer 3 can be omitted.

According to the embodiments of the present invention, it is possible to form a dense gate insulating layer, and reduce the thickness of the gate insulating layer and the process time, while improving the electrical properties of the TFT device by reducing its leakage current. Therefore, on the one hand, the present invention inhibits the influence of a surface state between an active layer and a gate insulating layer; on the other hand, a dense gate insulating layer facilitates in reducing a leakage current of a TFT device.

Further, the step of oxidizing a semiconductor is not limited to a process of heating in an oxidizing atmosphere as described above, but may adopt any suitable oxidation method. For example, it is also possible to oxidize a portion of a semiconductor layer by implanting elements with an oxidizing property (e.g., an oxygen element or a nitrogen element). In this case, the position of an oxidized portion can be controlled, for example, a portion at the bottom of the semiconductor layer can be oxidized.

It should be noted that, in the above-described structure of a TFT, the position relationship and connection relationship among various parts can be adjusted at will according to the prior art. For example, both the gate electrode and the source/drain electrodes may be provided above a gate insulating layer, and the source/drain electrodes are in contact with an active layer through openings in the gate insulating layer; alternatively, the gate electrode may be provided above the gate insulating layer, whereas the source/drain electrodes are provided below the active layer so as to be in direct contact with the active layer. The gate electrode may be provided above the active layer, and also may be provided below the active layer, as long as they are spaced by the gate insulating layer provided therebetween. In addition, in one embodiment, the first gate insulating layer of a TFT may have a dielectric strength of at least 9×106 V·cm-1. In addition, preferably, the first gate insulating layer may have a mass density of 2.0-3.5 g·cm-3.

TFTs according to embodiments of the present invention can be used in a display device such as a liquid crystal display. According to an embodiment of the present invention, there is further provided a display device, comprising: a thin film transistor in accordance with any embodiment of the present invention or a thin film transistor which is manufactured by a method in accordance with any embodiment of the present invention. As to other components of a display device, they are known to the skilled in the art. For example, these components include (but not limited to): a polarizing film, a common electrode, an alignment layer, sealant, liquid crystal, a spacer, a protective layer, an organic semiconductor active layer, anisotropic conductive adhesive film (ACF), a driver IC, a printed circuit board (PCB), a control IC, a black matrix (BM), and a color filter (CF).

## Claims

1. A thin film transistor, comprising:
a substrate (1),
an active layer (3),
a gate insulating layer,
a gate electrode (4) and source/drain electrodes (6),
wherein the gate insulating layer comprises a first gate insulating layer (5) in direct contact with the active layer (3),
**characterized in that** the active layer (3) is a polysilicon layer and the first gate insulating layer is a SiNₓ thin film with a density of 3.2-3.5 g·cm⁻³, a refractive index of 1.43-1.45, and a dielectric strength greater than 1×10⁷ V·cm⁻¹.

2. The thin film transistor according to Claim 1, wherein the first gate insulating layer (5) is obtainable by heating a semiconductor layer (3') used for forming the active layer (3) in an oxidizing atmosphere, the semiconductor layer (3') being a polysilicon layer.

3. The thin film transistor according to Claim 1 or 2, wherein the gate insulating layer further comprises a second gate insulating layer on the first gate insulating layer (5), the second gate insulating layer being obtainable through a chemical vapor deposition method or a sputtering method.

4. A display device, comprising a thin film transistor in accordance with any one of Claims 1-3.

5. A method for manufacturing a thin film transistor of claim 1, comprising the following steps:
providing a substrate (1);
forming a semiconductor layer (3') on the substrate (1);
forming a gate insulating layer; and
forming a gate electrode (4),
wherein the gate insulating layer comprises a first gate insulating layer (5), the first gate insulating layer (5) being formed by oxidizing a portion of the semiconductor layer (3'), and the unoxidized portion of the semiconductor layer (3') forming an active layer (3), and
wherein the gate electrode (4) is formed in such a way that the gate insulating layer (5) is sandwiched between the gate electrode (4) and the active layer (3),
**characterized in that** the first gate insulating layer (5) is formed by heating the semiconductor layer (3') in an oxidizing atmosphere, wherein
the oxidizing atmosphere having an oxygen content in volume of greater than 98%, and a water content in volume of less than 10 ppm, wherein the semiconductor layer (3') is a polysilicon layer, and the first insulating layer is formed by heating the polysilicon layer in a nitrogen-containing atmosphere to form SiNₓ; or,
the oxidizing atmosphere having an oxygen content in volume of greater than 97%, and a water content in volume of 10-1000 ppm, wherein the semiconductor layer (3') is the polysilicon layer, and the first gate insulating layer is formed by heating the polysilicon layer in a nitrogen-containing atmosphere to form SiNₓ.

6. The method according to Claim 5, wherein oxidizing the portion of the semiconductor layer (3') comprises:
performing the heating by convection heating or laser heating.

7. The method according to Claim 5 or 6, wherein after the formation of the gate electrode (4), openings are formed in the gate insulating layer at both sides of the gate electrode (4) to expose the active layer (3), and source/drain electrodes (6) are formed at the locations of the openings so as to contact with the active layer (3).

8. The method according to Claim 5 or 6, wherein source/drain electrodes (6) are formed before the formation of the semiconductor layer (3'), and the semiconductor layer (3') is formed over and in contact with the source/drain electrodes (6).

9. The method according to any one of Claims 6-8, wherein the temperature for heating the semiconductor layer (3') is 1000°C.

10. The method according to any one of Claims 5-9, wherein the semiconductor layer (3') is a polysilicon layer.

11. The method according to Claim 10, wherein the first gate insulating layer (5) is formed by heating the polysilicon layer in the oxygen-containing atmosphere to generate SiO₂ at a surface of the polysilicon layer.

12. The method according to Claim 10, wherein the first gate insulating layer (5) is formed by heating the polysilicon layer in the nitrogen-containing atmosphere to generate SiNₓ at a surface of the polysilicon layer.

13. The method according to Claim 12, wherein the nitrogen-containing atmosphere contains N₂ or NH₃.

14. The method according to any one of Claims 5-13, wherein forming the gate insulating layer further comprises: forming a second gate insulating layer on the first gate insulating layer (5) by a chemical vapor deposition method or a sputtering method.

15. The method according to any one of Claims 5-14,
wherein before the formation of the semiconductor layer (3'), a buffer layer (2) is formed on the substrate (1), and
wherein the semiconductor layer (3') is formed by forming an amorphous silicon layer on the buffer layer (2) and crystallizing the amorphous silicon layer into a polysilicon layer with the use of an excimer laser method.

## Patentansprüche

1. Dünnschichttransistor, mit:
einem Substrat (1),
einer aktiven Schicht (3),
einer Gate-Isolierschicht,
einer Gate-Elektrode (4) und Source-/Drain-Elektroden (6),
wobei die Gate-Isolierschicht eine erste Gate-Isolierschicht (5) in direktem Kontakt mit der aktiven Schicht (3) aufweist,
**dadurch gekennzeichnet, dass** die aktive Schicht (3) eine Polysiliziumschicht ist und die erste Gate-Isolierschicht eine SiNx-Dünnschicht mit einer Dichte von 3,2-3,5 g-cm-3, einem Brechungsindex von 1,43-1,45 und einer Durchschlagsfestigkeit von mehr als 1×107 V-cm-1 ist.

2. Dünnschichttransistor nach Anspruch 1, wobei die erste Gate-Isolierschicht (5) durch Erhitzen einer zur Bildung der aktiven Schicht (3) verwendeten Halbleiterschicht (3') in einer oxidierenden Atmosphäre erhältlich ist, wobei die Halbleiterschicht (3') eine Polysiliziumschicht ist.

3. Dünnschichttransistor nach Anspruch 1 oder 2, wobei die Gate-Isolierschicht ferner eine zweite Gate-Isolierschicht auf der ersten Gate-Isolierschicht (5) aufweist, wobei die zweite Gate-Isolierschicht durch ein chemisches Gasphasenabscheidungsverfahren oder ein Sputterverfahren erhältlich ist.

4. Anzeigevorrichtung, die einen Dünnschichttransistor nach einem der Ansprüche 1-3 aufweist.

5. Verfahren zur Herstellung eines Dünnschichttransistors nach Anspruch 1, das die folgenden Schritte aufweist:
Bereitstellen eines Substrats (1);
Bilden einer Halbleiterschicht (3') auf dem Substrat (1);
Bilden einer Gate-Isolierschicht; und
Bilden einer Gate-Elektrode (4),
wobei die Gate-Isolierschicht eine erste Gate-Isolierschicht (5) aufweist, wobei die erste Gate-Isolierschicht (5) durch Oxidieren eines Teils der Halbleiterschicht (3') gebildet wird, und der nicht-oxidierte Teil der Halbleiterschicht (3') eine aktive Schicht (3) bildet, und
wobei die Gate-Elektrode (4) so gebildet wird, dass die Gate-Isolierschicht (5) sandwichartig zwischen der Gate-Elektrode (4) und der aktiven Schicht (3) angeordnet ist,
**dadurch gekennzeichnet, dass** die erste Gate-Isolierschicht (5) durch Erhitzen der Halbleiterschicht (3') in einer oxidierenden Atmosphäre gebildet wird, wobei
die oxidierende Atmosphäre einen Sauerstoffgehalt in Volumen von mehr als 98% und einen Wassergehalt in Volumen von weniger als 10 ppm aufweist, wobei die Halbleiterschicht (3') eine Polysiliziumschicht ist und die erste isolierende Schicht durch Erhitzen der Polysiliziumschicht in einer stickstoffhaltigen Atmosphäre unter Bildung von SiNx gebildet wird; oder,
die oxidierende Atmosphäre einen Sauerstoffgehalt in Volumen von mehr als 97% und einen Wassergehalt in Volumen von 10-1000 ppm aufweist, wobei die Halbleiterschicht (3') die Polysiliziumschicht ist und die erste Gate-Isolierschicht durch Erhitzen der Polysiliziumschicht in einer stickstoffhaltigen Atmosphäre unter Bildung von SiNx gebildet wird.

6. Verfahren nach Anspruch 5, wobei das Oxidieren des Teils der Halbleiterschicht (3') aufweist:
Durchführen des Erhitzens durch Konvektionserwärmung oder Lasererwärmung.

7. Verfahren nach Anspruch 5 oder 6, wobei nach der Bildung der Gate-Elektrode (4) Öffnungen in der Gate-Isolierschicht auf beiden Seiten der Gate-Elektrode (4) gebildet werden, um die aktive Schicht (3) freizulegen, und Source/Drain-Elektroden (6) an den Stellen der Öffnungen gebildet werden, um die aktive Schicht (3) zu kontaktieren.

8. Verfahren nach Anspruch 5 oder 6, wobei Source-/Drain-Elektroden (6) vor der Bildung der Halbleiterschicht (3') gebildet werden, und die Halbleiterschicht (3') über und in Kontakt mit den Source-/Drain-Elektroden (6) gebildet wird.

9. Verfahren nach einem der Ansprüche 6-8, wobei die Temperatur zum Erhitzen der Halbleiterschicht (3') 1000°C beträgt.

10. Verfahren nach einem der Ansprüche 5-9, wobei die Halbleiterschicht (3') eine Polysiliziumschicht ist.

11. Verfahren nach Anspruch 10, wobei die erste Gate-Isolierschicht (5) durch Erhitzen der Polysiliziumschicht in der sauerstoffhaltigen Atmosphäre gebildet wird, um SiO₂ an einer Oberfläche der Polysiliziumschicht zu erzeugen.

12. Verfahren nach Anspruch 10, wobei die erste Gate-Isolierschicht (5) durch Erhitzen der Polysiliziumschicht in der stickstoffhaltigen Atmosphäre gebildet wird, um SiNx an einer Oberfläche der Polysiliziumschicht zu erzeugen.

13. Verfahren nach Anspruch 12, wobei die stickstoffhaltige Atmosphäre N2 oder NH3 enthält.

14. Verfahren nach einem der Ansprüche 5-13, wobei das Bilden der Gate-Isolierschicht ferner aufweist: Bilden einer zweiten Gate-Isolierschicht auf der ersten Gate-Isolierschicht (5) durch ein chemisches Gasphasenabscheidungsverfahren oder ein Sputterverfahren.

15. Das Verfahren nach einem der Ansprüche 5-14,
wobei vor der Bildung der Halbleiterschicht (3') eine Pufferschicht (2) auf dem Substrat (1) gebildet wird, und
wobei die Halbleiterschicht (3') durch Bilden einer amorphen Siliziumschicht auf der Pufferschicht (2) und Kristallisieren der amorphen Siliziumschicht zu einer Polysiliziumschicht unter Verwendung eines Excimerlaserverfahrens gebildet wird.

## Revendications

1. Transistor à film mince, comprenant :
un substrat (1) ;
une couche active (3) ;
une couche d'isolation de grille ; et
une électrode de grille (4) et des électrodes de source/drain (6) ;
dans lequel la couche d'isolation de grille comprend une première couche d'isolation de grille (5) en contact direct avec la couche active (3) ;
**caractérisé en ce que** la couche active (3) est une couche en polysilicium et la première couche d'isolation de grille est un film mince en SiNₓ qui présente une densité de 3,2 à 3,5 g·cm⁻³, un indice de réfraction de 1,43 à 1,45 et une résistance diélectrique supérieure à 1 × 10⁷ V·cm⁻¹.

2. Transistor à film mince selon la revendication 1, dans lequel la première couche d'isolation de grille (5) peut être obtenue en chauffant une couche semiconductrice (3') qui est utilisée pour former la couche active (3) dans une atmosphère d'oxydation, la couche semiconductrice (3') étant une couche en polysilicium.

3. Transistor à film mince selon la revendication 1 ou 2, dans lequel la couche d'isolation de grille comprend en outre une seconde couche d'isolation de grille sur la première couche d'isolation de grille (5), la seconde couche d'isolation de grille pouvant être obtenue par l'intermédiaire d'un procédé de dépôt chimique en phase vapeur ou d'un procédé de pulvérisation.

4. Dispositif d'affichage, comprenant un transistor à film mince selon l'une quelconque des revendications 1 à 3.

5. Procédé pour fabriquer un transistor à film mince selon la revendication 1, comprenant les étapes qui suivent :
la fourniture d'un substrat (1) ;
la formation d'une couche semiconductrice (3') sur le substrat (1) ;
la formation d'une couche d'isolation de grille ; et
la formation d'une électrode de grille (4) ;
dans lequel la couche d'isolation de grille comprend une première couche d'isolation de grille (5), la première couche d'isolation de grille (5) étant formée en oxydant une partie de la couche semiconductrice (3'), et la partie non oxydée de la couche semiconductrice (3') formant une couche active (3) ; et
dans lequel l'électrode de grille (4) est formée de telle sorte que la couche d'isolation de grille (5) soit prise en sandwich entre l'électrode de grille (4) et la couche active (3) ;
**caractérisé en ce que** la première couche d'isolation de grille (5) est formée en chauffant la couche semiconductrice (3') dans une atmosphère d'oxydation ; dans lequel
l'atmosphère d'oxydation présente une teneur en oxygène en volume supérieure à 98 %, et une teneur en eau en volume inférieure à 10 ppm, dans lequel la couche semiconductrice (3') est une couche en polysilicium, et la première couche d'isolation de grille est formée en chauffant la couche en polysilicium dans une atmosphère contenant de l'azote pour former du SiNₓ ; ou
l'atmosphère d'oxydation présente une teneur en oxygène en volume supérieure à 97 %, et une teneur en eau en volume de 10 à 1000 ppm, dans lequel la couche semiconductrice (3') est la couche en polysilicium, et la première couche d'isolation de grille est formée en chauffant la couche en polysilicium dans une atmosphère contenant de l'azote pour former du SiNₓ.

6. Procédé selon la revendication 5, dans lequel l'oxydation de la partie de la couche semiconductrice (3') comprend :
la réalisation du chauffage au moyen d'un chauffage par convection ou d'un chauffage par laser.

7. Procédé selon la revendication 5 ou 6, dans lequel, après la formation de l'électrode de grille (4), des ouvertures sont formées dans la couche d'isolation de grille au niveau des deux côtés de l'électrode de grille (4) afin d'exposer la couche active (3), et des électrodes de source/drain (6) sont formées au niveau des localisations des ouvertures de manière à ce qu'elles entrent en contact avec la couche active (3).

8. Procédé selon la revendication 5 ou 6, dans lequel des électrodes de source/drain (6) sont formées avant la formation de la couche semiconductrice (3'), et la couche semiconductrice (3') est formée au-dessus des électrodes de source/drain (6) et en contact avec celles-ci.

9. Procédé selon l'une quelconque des revendications 6 à 8, dans lequel la température pour chauffer la couche semiconductrice (3') est de 1000 °C.

10. Procédé selon l'une quelconque des revendications 5 à 9, dans lequel la couche semiconductrice (3') est une couche en polysilicium.

11. Procédé selon la revendication 10, dans lequel la première couche d'isolation de grille (5) est formée en chauffant la couche en polysilicium dans l'atmosphère contenant de l'oxygène afin de générer du SiO₂ au niveau d'une surface de la couche en polysilicium.

12. Procédé selon la revendication 10, dans lequel la première couche d'isolation de grille (5) est formée en chauffant la couche en polysilicium dans l'atmosphère contenant de l'azote afin de générer du SiOₓ au niveau d'une surface de la couche en polysilicium.

13. Procédé selon la revendication 12, dans lequel l'atmosphère contenant de l'azote contient du N₂ ou du NH₃.

14. Procédé selon l'une quelconque des revendications 5 à 13, dans lequel la formation de la couche d'isolation de grille comprend en outre : la formation d'une seconde couche d'isolation de grille sur la première couche d'isolation de grille (5) au moyen d'un procédé de dépôt chimique en phase vapeur ou d'un procédé de pulvérisation.

15. Procédé selon l'une quelconque des revendications 5 à 14,
dans lequel, avant la formation de la couche semiconductrice (3'), une couche tampon (2) est formée sur le substrat (1) ; et
dans lequel la couche semiconductrice (3') est formée en formant une couche en silicium amorphe sur la couche tampon (2) et en cristallisant la couche en silicium amorphe selon une couche en polysilicium à l'aide de l'utilisation d'un procédé par laser excimer.
